(19) Europäisches Patentamt
European Patent Office
Office européen des brevets

(11) Publication number: **0 275 103**
**A2**

# (12) EUROPEAN PATENT APPLICATION

(21) Application number: 88100458.4

(51) Int. Cl.4: **H 05 K 13/00**

(22) Date of filing: 14.01.88

(30) Priority: 14.01.87 JP 6553/87

(43) Date of publication of application: 20.07.88 Bulletin 88/29

(84) Designated Contracting States: AT BE CH DE ES FR GB GR IT LI LU NL SE

(71) Applicant: SANYO ELECTRIC CO., LTD.
18, Keihanhondori 2-chome
Moriguchi-shi Osaka-fu (JP)

(72) Inventor: Hineno, Kazuhiro 2140, Kamikoizumi
Oizumimachi, Ora-gun
Gunma-ken (JP)

Nushiyama, Shuuji 1939-24, Shimokoizumi
Oizumimachi, Ora-gun
Gunma-ken (JP)

(74) Representative: Patentanwälte Schaumburg & Thoenes
Mauerkircherstrasse 31 Postfach 86 07 48
D-8000 München 80 (DE)

## (54) Electronic parts automatic mounting apparatus.

(57) The present invention discloses an electronic parts automatic mounting apparatus in which a plurality of suction nozzles are provided on the peripheral edge of an intermittently rotating turntable, tip-like electronic parts delivered from a part supply portion are suctioned and held by the suction nozzles, the electronic parts being transferred, positioned and mounted on a print substrate placed on an X-Y table by the intermittent rotation of the turntable, the apparatus being provided with parts adjusting means for subjecting the electronic parts suctioned and held by the suction nozzles to various stepwise adjusting works at a plurality of working stations provided on the way of transferring thereof, wherein the part adjusting means comprises a plurality of positioning working units for positioning electronic parts arranged in correspondence to one part positioning station of the working units, each of the positioning working units being selectively actuated according to the form of electronic parts having different sizes and shapes, whereby the positioning of the tipped parts prior to mounting them on the print substrate can be carried out with high accuracy, and the necessity is eliminated to replace apparatus per se according to the form of the tipped parts having different sizes and shapes.

EP 0 275 103 A2

**Description**

# ELECTRONIC PARTS AUTOMATIC MOUNTING APPARATUS

## 2. BACKGROUND OF THE INVENTION

### 1. Field of the Invention

The present invention relates to an automatic mounting apparatus for electronic parts, and more particularly, to an automatic mounting apparatus provided with a part adjusting function, in automatically positioning and mounting on a print substrate tipped electronic parts (hereinafter referred to as tipped part(s)), for example, such as resistors, capacitors or transisters, by which the tipped parts may be positioned and adjusted according to the form of the tipped parts of different sizes and shapes.

### 2. Prior Art

In the past, the electronic parts automatic mounting apparatus of this kind has been known, for example, as disclosed in Japanese Utility Model Application Laid-Open No. 57-48672 previously filed by the present applicant, in which a tipped part seal-in tape wound and accommodated in a tape reel is intermittently drawn and delivered, the tipped parts are supplied to a fixed part-removing station, the tipped parts supplied to the part-removing station are suctioned by a plurality of suction nozzles which are provided mov ably up and down below the lower portion of the peripheral edge in the circumferential direction of an intermittently rotating turntable, and the tipped parts are mounted on a table which is movable and controllable in all directions (in an X-Y direction) while positioning and defining the tipped parts suctioned and held by the suction nozzles.

The positioning apparatuses for the tipped parts suctioned and held by the suction nozzles in the automatic mounting apparatus as described have been proposed, for exaample, as disclosed in Japanese Patent Application Laid-Open No. 56-24,997 and Japanese Utility Model Application Laid-Open No. 58-136,288 Specifications, in which the direction of the tipped parts are positioned according to the arranging mode thereof onto a print substrate by urging the tipped parts from all directions with use of positioning pawl members in the fixed positioning station, and as disclosed in Japanese Patent Application Laid-Open No. 61-168,298 Specification in which the position and shape of the tipped parts are recognized in advance by optical means, and therafter the suction nozzles by which the tipped parts are suctioned and held are rotated to thereby position the direction of the tipped parts and simultaneously correct a deviation in position of the rotating direction thereof at the time of suction.

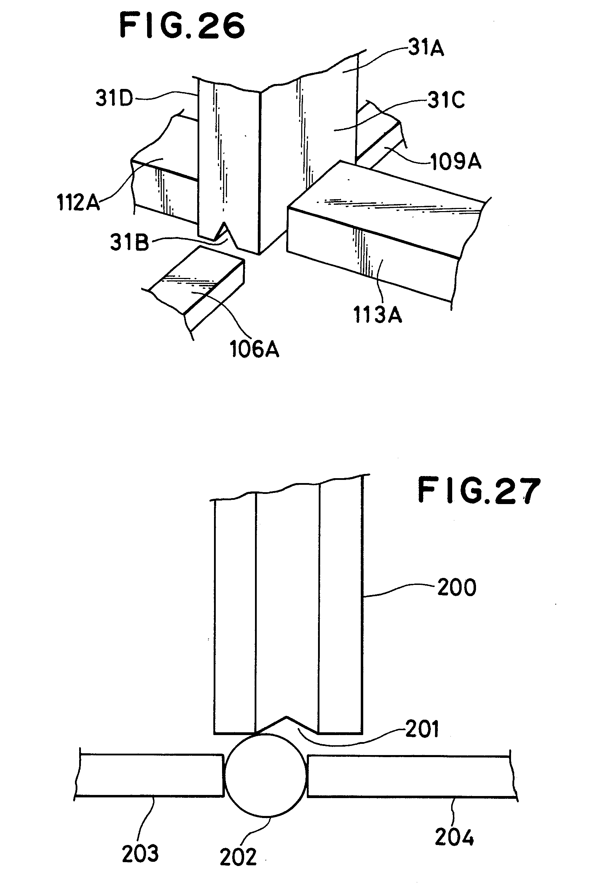

However, in the aforementioned conventional various positioning apparatuses and in the apparatus disclosed in Japanese Patent Application Laid-Open No. 56-24,997 Specification, the positioning and the rotation to adjust the direction of the tipped parts cannot be effected at the same time, failing to attain a higher speed. In addition, for example, in the apparatus disclosed in Japanese Utility Model Application Laid-Open No. 58-136,288 in which as shown in FIG. 27, a V-shaped notched groove 201 is formed at the end of a suction nozzle 200 to suction and hold a cylindrical tipped part, when a center between the V-shaped notched groove 201 at the end of the suction nozzle 200 and each of the positioning pawl members 203 and 204 is deviated from each other, the cylindrical tipped part 202 tends to be positioned by the positioning pawl members 203 and 204 under the unstable state wherein the tipped part 202 is not fitted in the V-shaped notched groove 201. In addition, when the tipped part 202 is released from each of the positioning pawl members 203 and 204 after completion of the positioning, the tipped part 202 sometimes becomes deviated due to the movement thereof in such a way that the tipped part 202 is fitted into the notched groove 201 under the influence of the suction force of the suction nozzle 200. For this reason, difficult adjustment by which the direction of the notched groove 201 at the end of the suction nozzle and the direction of each of the positioning pawl members 203 and 204 are brought into precise coincidence has to be carried out for each suction nozzle, and moreover, the apparatus per se need be replaced according to the form of tipped parts of different sizes and shapes.

Futhermore, in the apparatus disclosed in Japanese Patent Application Laid-Open No. 61-168,298 Specification, when the rotational center between the suction nozzles is deviated, the position of the tipped parts after rotation becomes deviated, and therefore, a troublesome adjusting work for precisely adjusting the rotational center of the each of the suction nozzles need be carried out.

## 3. SUMMARY OF THE INVENTION

The present invention overcomes inconveniences inherent in the above-described conventional electronic parts automatic mounting apparatus. It is a principal object of the present invention to provide an electronic parts automatic mounting apparatus in which a plurality of suction nozzles are provided on the peripheral edge of an intermittently rotating turntable, tip-like electronic parts delivered from a part supply portion are suctioned and held by these suction nozzles, and electronic parts being transferred, positioned and mounted on a print substrate placed on an X-Y table by the intermittent rotation of said turntable, said apparatus being provided with part adjusting means for subjecting the electronic parts suctioned and held by said suction nozzles to various stepwise adjusting works at a plurality of working stations provided on the way of transferring thereof, wherein said part adjusting means comprises a plurality of positioning working units for positioning electronic parts arranged in correspondence to one part positioning station of the working units, each of said positioning working units being selectively actuated according to the form of electronic parts having different sizes and shapes. With this arrangement, the positioning of the tipped parts prior to mounting them on the print substrate can be carried out precisely, and furthermore, the necessity of replacing apparatus per se according to the form of the tipped parts having different sizes and shapes can be eliminated.

It is a further object of the invention to provide an arrangement wherein said part adjusting means comprises a working station for detecting onto said suction nozzles prior to positioning of tip-like electronic parts, and a working station for detecting presence or absence and attitude of electronic parts onto said suction nozzles after positioning of tip-like electronic parts. With this arrangement, this makes it possible to positively carry out the confirmation of presence of the electronic parts being transferred by the suction nozzles.

It is another object of the invention to provide an arrangement wherein said part adjusting means comprises a part-rotating working station separately from the position ing working station for the tip-like electronic parts. With this arrangement, is is possible to positively carry out the positioning of the electronic parts being transferred by the suction nozzles.

It is a still another object of the invention to provide an arrangement wherein said suction nozzle is held by means of a holder said holder being synchronized with the rotation of a turntable so that the holder may be moved upward and downward. With this arrangement, it is possible to smoothly carry out the suctioning and holding of the electronic parts by the suction nozzles and mounting them on the print substrate, thus attaining a higher speed service.

It is another object of the present invention to provide an arrangement wherein means for positioning the suction nozzles per se is provided to thereby increase the positioning accuracy of the tipped parts prior to mounting them onto the print substrate.

It is a further object of the present invention to provide an arrangement wherein means for rapidly moving down the suction nozzles at a station located before a part mounting station while being guided by a vertical rail to thereby provide high-speed mounting of the parts onto the print substrate.

## 4. BRIEF DESCRIPTION OF THE DRAWINGS

FIG. 1 is a schematic front view showing one embodiment of the entire structure of an electronic parts automatic mounting apparatus according to the present invention;

FIG. 2 is a schematic plan view of the same;

FIG. 3 is a schematic side view of the same;

FIG. 4 is a longitudinal sectional view of a turntable;

FIG. 5 is a longitudinal sectional view of a suction nozzle;

FIG. 6 is a longitudinal sectional view of a principal part showing the rotating state of the suction nozzle;

FIGS. 7 and 8 are respectively plan views showing a rotating mechanism for the suction nozzles;

FIGS. 9 and 10 are respectively plan views showing in section of the principal part of a suction mechanism by way of a switching valve of the suction nozzles;

FIG. 11 is a schematic plan view of a positioning device arranged in a positioning working station;

FIG. 12 is a schematic plan view of a positioning working unit;

FIG. 13 is a schematic side view of the positioning working unit;

FIG. 14 is a schematic longitudinal sectional view of the principal part of the positioning working unit;

FIGS. 15 and 16 are respectively sectional views showing the positioning state or tipped parts by means of positioning pawl members;

FIG. 17 is an explanatory view showing the displacement of upper and lower levels of the suction nozzles;

FIG. 18 is a side view schematically showing the vertically moving operation of the suction nozzles in the working station installed on the way thereof after the parts have been positioned;

FIGS. 19 and 20 are respectively explanatory views schematically showing the operation of upper and lower rails adapted to move the suction nozzles upward and downward;

FIGS. 21 to 23 are respectively explanatory views showing the vertically moving state of the X-Y table;

FIG. 24 is a schematic sectional view of the positioning working unit;

FIG. 25 is a perspective view schematically showing the end portion of the suction nozzle; and

FIG. 26 is a schematic explanatory view showing the operating state of the positioning pawl member.

FIG. 27 is an explanatory view of principal parts schematically showing the operating state of conventional suction nozzles and positioning pawl members.

## 6. DETAILED DESCRIPTION OF THE INVENTION

In the following, the specific mode of a part supply device according to the present invention will be described in detail with reference to the embodiment shown in the accompanying drawings.

As shown in FIGS. 1 to 3, in the drawings, reference numeral 1 designates a base bed, 2 a supply conveyor for placing thereon a print substrate to supply and transfer it, and 3 a transfer device for transferring the print substrate on the supply conveyor 2 to an XY table 4. The device 3 is rotatably supported at one end by means of a support shaft 5 and can be moved along a rail 6. When the print substrate is transported by the supply conveyor 2, a pair of feed pawls 7 and 8 are rotated about said support shaft 5 and moved downward, and the device 3 moves rightward as viewed in FIG. 2. This movement causes the print substrate on the XY table 4 to be moved rightward by one pawl 7, whereas at the same time, the other pawl 8 serves to transfer the print substrate on the supply conveyor onto the XY table 4.

The XY table 4 with the print substrate placed on said table from the transfer device 3 is moved downward (which assumes the state shown in FIG. 22 from FIG. 21) by means of drive means not shown whereby the XY table 4 may be moved in all directions. Numeral 10 designates a turntable, which is mounted on an index unit 11 rotated by a drive motor not shown and is intermittently rotated. In the peripheral edge of the table 10, eighteen (18) suction head 12 are provided movably upward and downward at equal intervals. Numeral 13 designates a part supply bed capable of being moved along a laterally extending rail 14, on which part supply bed are juxtaposed a plurality of tape supply units (supply means) 18 designed so that a tape 16 accommodating therein tip-like electronic parts or tipped parts 15 at equal intervals is wound about a reel 17 and the tape 16 is delivered every part array pitch. Numeral 19 designates a positioning device for positioning the tipped part 15 prior to mounting it to the print substrate. The XY table 4 when moved downward can be moved in the direction of X- and Y axes below the turntable 10 and the positioned device 19 (see FIG. 23).

Next, the aforesaid turntable 10 and the suction heads 12 will be described in detail in conjunction with FIGS. 4 and 5. Numeral 20 designates a cylindrical cam member for guiding a hollow cylindrical table suspended and secured to a mounting bed 11A of the index unit 11 so as to surround the upper portion of a cylindrical portion 21 formed above the turntable 10. The cam member 20 is formed at its peripheral side at the lower end with a cam 22 over the substantially entire periphery thereof, a roller 24 as a sliding portion provided onthe upper end of each of the suction heads 12 is rotated while being urged against the upper surface of the cam 22 by means of a spring 23, and the each of the suction heads 12 are moved upward and downward along a profile of the cam 22 and rotated along with the turntable 10. More specifically, each of the suction heads 12 are stood upright a pair of guide rods 25 which vertically movably extend through the turntable 10, and a mounting member 26 with a roller 24 rotatably provided thereon is secured to the upper end of the rod 25. Thus, each of the suction heads 12 are vertically movable supported on the turntable 10.

Next, the suction heads 12 will be described in detail in which they are rotated along with the table 10 while being moved upward and downward with respect to the turntable 10. First, a cylindrical body 27 is rotatably held through a bearing 29 within upper and lower blocks 28, and a gear 30 formed with teeth in the peripheral side integral with the cylindrical body 27 is meshed with a drive mechanism not shown from the exterior for rotation. Numeral 31 designates a suction nozzle interiorly formed with an intake passage 32 in communication with a vaccum pump as a vacuum source not shown to enable suctioning the tipped part 15 at the lower end thereof, the nozzle 31 being guided by means of a ball bearing 33 for upward and downward movements and rotation. In the upper end of the nozzle 31 is housed a dust-removing filter 35 that may be installed or removed from an upper opening 34, and a filter case 37 having a space 36 is secured to the lower portion of the filter 35. It is noted that the filter case 37 can be formed integral with the suction nozzle 31. Numeral 38 designates a filter accommodating portion detachably mounted on the upper portion of the cylindrical body 27 to form an accommodation chamber 40 whose interior is in the form of a cavity to receive the filter 35 and a spring 39. Accordingly, when the filter 35 is replaced, the filter accommodation portion 38 may be removed from the cylindrical body 27 and the filter 35 may be installed and removed from the upper opening 34. On the upper end of the accommodation chamber 40 is rotatably provided a spring shoe 41 adapted to lock the upper end of the sprint 39, and the nozzle 31 is downwardly biased by means of the spring 39. The spring 39 serves to function as a damper when mounting the tipped parts 15 of different heights. While the aforesaid filter 35 has been provided above the suction nozzle 31, it is to be noted that the filter is not limited to said location but can be provided anywhere as long as they are integral with the suction nozzle 31, for example, at the lower portion within the nozzle.

The cylindrical body 27 is provided with three suction nozzles 27 at fixed angles, and the filter accommodation portion 38 is formed with three accommodation chambers 40, respectively. One of the suction nozzle 31A presents at its lower portion a rectangular parallelpiped as shown in FIGS. 25 and 26 and is formed at its bottom surface with groove 31B in the V-shape sectioned lengthwise so that when the cylindrical tipped part 15A is suctioned by the nozzle 31A, the cylindrical peripheral surface comes into contact with two surfaces of the groove 31B along the groove 31B, the tipped part 15A not being wholly received into the groove 31B but the lower portion of the part 15A is buldged out. The suction nozzle 31A is formed with mutually parallel planes 31C and 31D in parallel with the longitudinally extending groove 31B. The dimension L2 between these planes 31C and 31D is slightly longer than the diameter of the part 15A.

In the peripheral side portion of the cylindrical body 27 are formed with three communication chambers 43 capable of being communicated with a hose 42 as a connection body in communication with a vacuum pump, the communication chambers 43 being communicated with the accommodation chamber 40 through communication passages 44, respectively. Accordingly, only one suction nozzle 31 can be connected to said hose 42 through the accommodation chamber 40, the communication passage 41 and the communication chamber 43. The other two suction nozzles 31 not participated in the suctioning operation have a flange surface 47 upwardly raised by means of a keep lever 46 upwardly biased by means of a spring 45. Numeral 48 designates an engaging member adapted to downwardly force the lever 46.

In the following, the rotating device for rotating the suction nozzle 31 per se will be described. A rotating roller 50 is pressed against a projection 51 formed in the cylindrical side of the suction nozzle 31 from the outside, and the rotating roller 50 is rotated by a drive motor 52 through a belt 53, whereby the nozzle 31 may be rotated at a fixed angle.

Next, a connection switching device 49 will be described in detail with reference to FIGS. 7 and 8. A pivotable lever 55 about a pivot pin 54 has a pawl 56, which engages between the teeth of the gear 30 provided on the cylindrical body 27 to impede the rotation of the cylindrical body 27, integral with a joint 57 connected to said hose 42. Numeral 58 designates an engaging body, and a spring 59 is provided between the engaging body 58 and said lever 55 so that said sprint 59 is always biased to cause the pawl 56 to engage the gear 30. The end of the joint 57 is formed into a reduced diameter portion, offset portion of which is provided a stopper 60, and a seal packing 61 as a ring-like or cylindrical seal member is wound about the reduced diameter portion so that the end may abut with the stopper 60. Accordingly, where the pawl 56 is being engaged with the gear 30 by the spring 59, the joint 57 and the communication chamber 43 are communicated with each other so as not to produce a vacuum leak under the completely sealed condition by said packing 61.

In the case where the joint 57 is brought into communication with the other communication chamber 43, the lever 55 is rotated by a drive mechanism not shown so that the joint 57 and the pawl 56 are moved away from the cylindrical body 27 and the gear 30, respectively, and the cylindrical body 27 may be rotated (see FIG. 8). It is of course to be noted that an open end of teh communication chamber 43 of the cylindrical body 27 is circular and the open peripheral edge is formed into a planar shape.

On the other hand, the construction of the other end of the hose 42 will be described. The other end of the hose 42 is connected to a connection hose 62 which extends through the turntable 10 and is embedded, the connection hose 62 being communicated with a vacuum pump (not shown) through a switching valve 63, a laterally extending intake passage 64 and a central intake passage 65 of the cylindrical body 27.

The aforementioned switching valve 63 will be described in detail with reference to FIGS. 9 and 10. A valve stem 66 is slidably mounted on a bearing body 67, and a valve body 68 is mounted on the end of the valve stem 66. In the FIG. 9 state, a spring 69 causes the valve body 68 to close an end opening of the latrally extending intake passage 64 of the turntable 10 to shut off the vacuum circuit formed by the vacuum pump. The valve stem 66 is bored with an atmosphere communication passage 70 through which the valve body does not extend, and the side of the communication passage 70 closer to the valve body 68 is bored with a lateral hole 71 so that a valve chamber 72 can be communicated with the atmosphere. More specifically, in the state where the valve body 68 closes the intake passage 64, the valve chamber 72 is connected with the atmosphere through the lateral hole 71 and the communication passage 70, and when the valve body 68 opens the intake passage 64, the lateral hole 71 is closed by the baring body 67 to form a vacuum circuit. A collar 73 is mounted on the other end of the valve stem 66, and a first lever 75, one end of which is pivotally supported by a pin 74, has the other end in contact with the collar 73. An approximately ⌝-shaped second lever 76 is pivotably supported at its intermediate portion by a pin 77, and rotatable rollers 78 and 79 are provided on opposite ends thereof. With this, when the second lever is swung by means of a drive source not shown, one roller 78 becomes engageable with a first recess 80 and a second recess 81 of the first lever 75 beyond a projection 82.

It will be noted that high pressure air is blown through the end on the atmosphere side of the valve stem 66 whereby the vacuum circuit to each of the suction nozzles 31 may be forcibly shut off or the aforesaid vacuum circuit may be cleaned.

Next, the positioning device 19 will be described in detail. As shown in FIG. 11, the aforesaid turntable 10 turns around working stations A to R, and the positioning stations D, E and F are provided with positioning devices 83, 84 and 85, respectively. The positioning device 83 is of the conventional construction and will be briefly explained. A belt 89 is extended between an output shaft pulley 87 of a drive motor 86 and a positioning unit 88, and a positioning pawl not shown may be rotated. With respect to the positioning devices 84 and 85 in the positioning stations E and F, they will be described taking the device 84 as an example with reference to FIGS. 12 and 13. The positioning device 84 has two positioning units 90 and 91, and either units 90 and 91 may be moved to the position immediately under the suction nozzle 31 in the station E by a drive cylinder 92 in accordance with a program of a controller determined in advance according to the sizes of the tipped parts 15. The units 90 and 91 are provided movable with respect to a frame 93, and the frame 93 is linearly moved by contact of two pairs of guides 94 with a guide rail 95 from the side thereof.

The units 90 and 91 are disposed with a spacing L1 left in the foremost end of the frame 93, and a belt 98 is extended between the units 90, 91 and an output shaft pulley 97 of a drive motor so that as the pulley 97 rotates, the units 90 and 91 are rotated in synchronism therewith. A line connecting centers of the units 90 and 91 is parallel with a moving direction of the frame 93 which moves along the guide rail 95. The moving amount of the frame 93 connected through a connection member 100 to a rod 99 of the drive cylinder 92 is defined by a backward-movement limiting stopper 101 secured to a fixed portion of the cylinder 92 and a forward-movement limiting stopper 102 so that said moving amount is the same distance of said spacing L1. Therefore, if the center of the suction nozzle 31 is made in registration with the center of the positioning unit 90, when the drive cylinder 92 is actuated to automatically replace it to the unit 91, the center of the unit 91 becomes registered with the center of the suction nozzle 31.

In the following, the construction of the positioning units 90 and 91 will be described with reference to FIG. 14. When a pusher 103 is moved upward by means of a cam (not shown), a first opening and closing plate 105 is rotated about a pin 104 in a direction of opening a positioning pawl 106, and therefore, a second opening and closing plate 107 is also rotataed about a pin 108 in response to the rotation of the first opening and closing plate 105 to open the pawl 109. When a pusher 103 is moved downward, both the pawls 106 and 109 are closed by a spring 111 with one end thereof supported on a fixed portion 110 to hold the tipped part 115 suctioned by the suction nozzle 31 to position the part 15. The number of the positioning pawls are four per unit but the opening and closing of the other pair of pawls 112 and 113 are similarly constructed. Numeral 114 designates a stopper which is to limit the closing direction of the opening and closing plate 105.

The positioning pawls 106, 109, 112 and 113 are rotated, during the rotation of the turntable 10, by the drive motor 96 in the direction in which the tipped part 15 suctioned by the suction nozzle 31 is rotated, that is, in the direction adjusted to the direction when the part 15 is mounted on the print substrate. Then, when the suction nozzle 31 is moved downward, the positioning for only the centering operation is carried out.

As shown in FIGS. 15 and 16, most of the tipped parts 15 have a symmetrical shape, and therefore, where the tipped parts 15 are rotated through 180° and mounted on the print substrate, if the suction nozzle 31 is rotated as previously mentioned so that the tipped parts 15 are rotated in advance through 180°, the pawls 106, 109, 112 and 113 needs not be rotated during the rotation of the turntable 10.

The construction of the positioning unit 90 is substantially similar to that of the unit 91 but positioning pawls 112A and 113A have a thickness greater than that of the pawls 112 and 113. Accordingly, the pawls 112A and 113A will not position the cylindrical-shaped tipped part 15A per se but the suction nozzle 31A is positioned, as a result of which the direction of the center axis of the part 15A is positioned. In positioning the suction nozzle 31A, a dimension L2 between planes 31C abnd 31D of the nozzle 31A is made longer than the diameter of the part 15A. Therefore, the part 15A is not disengaged from a groove 31B and the tipped parts 15A are not displaced when both the pawls 112A and 113A. Also, the construction for opening and closing the other pair of positioning pawls 106A and 109A is similar to that of the aforementioned positioning unit 91 but the positioning pawls 112A and 113A serves to position the suction nozzle 31A per se whilst the axial direction of the cylindrical tipped part 15A is directly positioned. Accordingly, the horizontal width of both the pawls 106A and 109A is formed to be shorter than the dimension L2 between the planes 31C and 31D of the suction nozzle 31A and slightly longer than the tipped part 15A. A circular portion of a portion buldged out of the groove 31B is held to thereby position the axial direction of the tipped part 15A.

As described above, when the tipped parts 15 pass through the positioning stations D, E and F, the parts are positioned by any of the positioning units 88, 90, 91, 115 and 116 in any of the stations. However, which unit is used is selected according to the program of the controller depending on the sizes and shapes of the tipped parts 15. In the stations other than the thus selected station, the suction nozzle 13 will not be moved downward by a mechanism not shown and in addition, the non-selected positioning unit is not operated.

FIG. 17 shows the displacement of the upper and lower levels of the suction nozzle 31. In the working stations A, D, E, F and J, for performing the works it is moved away from the cam 22 to effect upper and lower operations. This can be achieved by provision of upper and lower rails (not shown), which is associated with the cam 22 or moved down, at the portion in which the cam 22 is interrupted.

In the working stations A, B, C, D, E, F and G, the positioning units 88, 90, 91, 115 and 116 for positioning the tipped parts 15, photosensors 117 and 118 as the presence or absence detection means for detecting presence or absence of the parts 15, and a photosensor 119 as detection means capable of being swung by a drive motor 120 for detecting the suction attitude are located below the suction nozzles 31, and therefore the parts 15 have to be moved at a high level. Particularly, in the station J, the suction nozzle 31 has to be moved down immediately above the print substrate because the tipped parts 13 are mounted.

Thus, in the station I, the nozzles are moved down at a dash to the level Z, from which starts to the next station J. The construction will be described in detail with respect to FIGS. 18, 19 and 20. FIG. 18 shows the state of the working stations H and I from the right-hand, in which the roller 24 at the upper end of the suction head 31, which has travelled on the cam 22 from the station H by rotation of the turntable 10 is moved onto the upper and lower rails 121 and carried to the next station I. The construction of the rail 121 will be described in detail with reference to FIGS. 19 and 20. The rail 121 is pivotable about a pin 122. The state wherein a stopper 121 biased by a spring 123 and projectingly provided on the rail 121 is in contact with a shaft 125 is the state at the upper portion in FIG. 19. The shaft 125 is moved upward and downward by a cam drive mechanism (not shown) to move the rail 121 upward and downward through the pin 122. A rotatable roller 126 is mounted on the end of the rail 121, and the roller 24 is moved away from the rail 121 by pushing down the roller 126 by a push-down member 127. That is, in the cam 22 of the cylindrical cam member 20, a part thereof in which the rail 121 is disposed is interrupted, and one end side of said interrupted place is greatly different in upper and lower positional relation from the other end side thereof, because of which the rail 121 is disposed at the interrupted portion for vertical movement. In the state as shown in FIG. 19, the cam 22A on one end side positioned upwardly and the rail 121 are in the same level, and thereafter the roller 24 is moved onto the rail 121 and then the rail 121 moves down together with the shaft 125, as a consequence of which the rail 121 assumes the same level as that of the lower cam 22B. When the roller 24 is then moved onto the lower cam 22B, the state of the station J. At this time, when the roller 126 is pushed down by the push-down member 127, the rail 121 is rotated as shown in FIG. 20, after which the rail 121 is moved upward to assume the same level as the upper cam 22A and the push-down member 127 also moves above the roller 126. While in the present embodiment, an example has been shown in which the rail 121 is used for the transfer from up to down, it is to be noted that the rail 121 is not limited thereto but can be used for the transfer from down to up in the case where there is a difference in the upper and lower positional relation.

While in the present invention, the tipped parts 15 are urged by the pawls 106, 109, 112 and 113 from all directions to perform the positioning in the direction of axis X and in the directionof axis Y, and the positioning in the direction of $\Theta$ by the drive motor 96 through the belt 98, it is to be noted that the arrangement is not limited thereto but for example, the position of the tipped parts 15 can be optically detected to rotate the suction nozzle 31 to thereby decide the positions in the directions of axes X and Y and decide the position in the direction of $\Theta$ at the XY table 4.

With the above-described arrangement, the operation will be described hereinafter. First, when the print substrate placed on the supply conveyor 2 is transported to arrive at the lower position of the transfer device 3, the conveyor 2 stops. The pari of the feed pawls 7 and 8 are rotated about the support shaft 5 and moved down, and the right pawl 7 comes into engagement with the left end of the print substrate on the XY table 4 whereas the left pawl 8 comes into engagement with the left end of the print substrate transported by the conveyor 2. Thereafter the transfer device 3 moves along the rail 6 to thereby transfer the substrate from the supply conveyor 2 to the XY table 4 and transfer the substrate on the table 4 onto the discharge conveyor 9, thus moving it rightward from the conveyor 9.

Then, the print substrate is positioned by the positioning device not shown on the XY table 4 but the transfer device 3 causes the feed pawls 7 and 8 to be moved upward and returns to its original position along the rail 6. The XY table 4 is moved down as shown in FIG. 22 by the drive means (not shown) and becomes movable in the longitudinal direction (in the direction of axis Y) and in the lateral direction (in the direction of axis X) (see FIG. 23) whereby the XY table 4 moves to the lower position of the turntable 10 and the positioning device 19. On the other hand, the state is that the supply bed 13 has already been moved along the rail 14 so that among the plurality of tape supply units 18 juxtaposed on the part supply bed 13, a suitable one of the units 18 is in opposition to the turntable 10, and the upper film of the tape 16 wound about the reel 17 is peeled off by the peeling mechanism not shown and the tipped part is in a position directly under the suction nozzle 31.

Now, the index unit is rotated by the motor and the turntable 10 is intermittently rotated.

First, in the suction station A or the first working station, the tipped part 15 is suctioned and chucked by the lower end of the suction nozzle 31 from the tape supply unit 18. In the station A, the lower end of the suction nozzle 31 of the suction nozzle 12 must be lowered to a level of the tape 16. This may be accomplished in such a way that the roller 24 on the upper end of the head is placed on the vertially movable rail (not shown) disposed in the interruppted portion of the cam 22 of the cam member 20. This suctioning is carried out in such a way that the joint 57 in communication with the communication chamber 43, the hose 42, the connection hose 62, the valve chamber 72, the laterally extending intake passage 64, the central intake passage 65 of the cylindrical portion 21 and the vacuum pump (not shown) are connected through the suction nozzle 31 of the suction head 12, the filter 35, the accommodation chamber 40 of the cylindrical body 27, the communication passage 44, the communication chamber 43 and the seal packing 61 to form the vaccum circuit.

The suction head 12 moved upward from the suction level is moved to the second working station B through the roller 24 slidably moving on the cam 22 of the cam member 20. In this station B, whether the suction nozzle 31 suctions the tipped part 15 is detected by the photosensor 117, and the suction nozzle 31 is rotated by the rotating device while suctioning the tipped part in the direction programmed in advance in the controller (not shown). More specifically, as shown in FIG. 6, the rotating roller 50 is pressed against the projection 51 of teh suction nozzle 31 from the outside, and the drive motor 52 is rotated to thereby rotate the rotating roller 50 by a fixed angle through the belt 53. After this rotation, the rotating roller 50 is moved away from the suction nozzle 31. In this manner, the tipped part 15 is rotated in advance prior to positioning so as to provide the direction when the tipped part 15 is mounted.

Next, in the working station C, in the case where the photosensor 117 has detected that in the second working station B, the suction nozzle 31 does not suction the tipped part 15, the vacuum circuit to the suction head 12 is shut off by the switching valve 63. That is, when the roller 70 is urged by the drive source not shown so that the mode is changed from the FIG. 11 state to the FIG. 9 state, the second lever 76 swings, and the roller 78 having engaged the second recess 81 of the first lever 75 moves beyond the projection 82 into the engagement with the first recess 80. Accordingly, the first lever 75 is also rotated clockwise, and the valve stem 66 is moved by the spring 69 so that the valve body 68 closes the laterally extending intake passage 64. Thereby, the suction nozzle 31 comes into communication with the atmosphere through the hose 42, the connection hose 62, the valve chamber 72, the lateral hole 71 of the valve stem 86 and the atmosphere connection passage 70.

In the working stations D, E and F, in the positioning station of the tipped parts 15, there indicates any of the positioning stations D, E and F in accordance with the fixed program depending on the shapes of the parts 15 and performs positioning at any of the positioning units 88, 90, 91, 115 and 116, and others have already been decided according to the prts when the tipped parts are suctioned in the suction station A. For example, if the right-hand positioning unit 91 is selected in the positioning station E, the frame 93 is moved through the spacing L1 along the guide rail 95 through the rod 99 by the drive cylinder 92, the position is decided by the forward-movement limiting stopper 101, and the unit 91 has already been moved before the suction nozzle 31 arrives at the position directly below the nozzle 31. At the time, the stations D and F are idle stations.

The positioning operation for the tipped parts 15 will be described hereinafter. First, when the cam (not shown) is moved upward by the pusher 103, the first and second opening and closing plates 105 and 107 are rotated about the pins 104 and 108, respectively, against the spring 111, and the positioning pawls 106, 109, 112 and 113 open. The suction nozzle 31 is moved dow by downward movement of the rail (not shown) on which the roller 24 on the upper end of the suction head 12. When the pusher 103 is moved down, they are held by the pawls 106, 109, 112 and 113 and positioned from all directions. After the pusher 103 has been again moved upward, the rail moves upward and the suction nozzle 31 also moves upward. Thereafter, the turntable is intermittently rotated through one division.

Subsequently, in the direction station G, whether the suction nozzle 31 suctions the tipped part 15 or whether the suction nozzle 31 suctions the tipped prt 15 in a normal position are detected by the photosensors 118 and 119. The sensor 119 can be swung by the drive motor 120 and checks the suction attitude of the tipped part 15. However, a single sensor can be used to detect the presence or absence and the attitude of a part.

In the ninth working station I, the suction nozzle 31 is rapidly moved down to the level Z, which will be described with reference to FIGS. 19 and 20. First, in the state shown in FIG. 19, the upper cam 22A is the same level as the rail 121. The roller 24 is moved onto the rail 121 and then the rail 121 together with the shaft 125 are moved down to assume the same level as the lower cam 22B. When the roller 24 is moved onto the lower cam 22B, the roller 126 is pushed down by the push-down member 127. Then, as shown in FIG. 20, the rail 121 is rotated against the spring 123, and thereafter the rail 121 is moved upward together with the shaft 125 to assume the same level as the cam 22A, and the push-down member 127 is also moved so as to be moved upwardly of the roller 126.

In the packaging station J or the tenth working station, the tipped part 15 is mounted on the print substrate on the XY table 4. For this reason, the suction nozzle 31 is moved down to the substrate by the rail not shown for carrying out the mounting.

More specifically, only in the case where the presence of the tipped part 15 is directly by the aforementioned photosensor 117, such presence is likewise detected by the photosensor 118 also in the detection station G and the judgement is made by the photosensor 119 to the effect that the suction attitude is normal, the switching valve 63 is actuated as described above whereby the laterally extending the intake passage 64 is closed by the valve body 68, the valve chamber 72 is brought into communication with the atmosphere through the atmosphere communication passage 70 of the valve stem 66 and the high pressure air is blown through the end on the atmosphere side of the valve stem 66 to thereby perform mounting as previously described. Accordingly, in the case where the presence of the tipped part 15 is not detected by the photosensors 117 and 118 or the judgement is made by the sensor 119 to the effect that the suction attitude is normal, the suction nozzle 31 will not be moved down to effect no mounting.

The succeeding stations K, L and M are idle stations. In the discharge station N, even if the presence of the tipped part 15 is detected by the photosensors 117 and 118, but the abnormality of the suction attitude is judged by the photosensors 117 and 118, the tipped part 15 is discharged from the lower end of the suction nozzle 31. That is, as described above, the vacuum circuit is shut off and the high pressure air is blown through the end of the valve stem 66.

Since at that time, the duct or the like drawn through the end of the suction nozzle 31 is interrupted by the filter 35 and stay within the space 36 of the filter case 37, the when the high pressure air is blown in in the aforementioned packaging station J and the discharge station N, the dust is discharged from the lower end of the nozzle 31 to automatically clean the filter 35 and its peripheral portion. Accordingly, when the vacuum circuit is formed, the dust or the like will not be stopped up in the circuit.

In the next station 0, which nozzle 31 among the three suction nozzles 31 of the suction head 12 is used is detected by the sensor not shown.

In the next nozzle selection station P, which suction nozzles 31, 31, 31 is next used on the basis of the data programmed by the controller is selected. In this selection, in case of using the tipped parts 15 of the same shapes and sizes, the same suction nozzle 31 can be used and the selection need not be carried out but they can be sequentially replaced. In case of using small tipped parts or large tipped parts, selection can be made so that suction nozzles corresponding thereto may be used.

This selecting operation or the operation of the connection switching device 49 will be described. To communicate the joint 5 with the other communication chamber 43, the lever 55 is rotated by the drive mechanism not shown, the joint 57 and the pawl 56 are moved away from the cylindrical body 27 and the gear 30, respectively, a gear not shown is meshed with the gear 30, and the cylindrical body 27 is rotated by said gear in the drive mechanism (not shown) through the bearing 29. This rotation is carried out in a way such that the keep lever 46 is downwardly rotated by the engaging member 48 to move downward all the suction nozzles 31, 31 and 31. The lever 55 is rotated so that the joint 57 is in communication with the communication chamber 43 corresponding to the selected suction nozzle 31 to bring the pawl 56 into engagement with the gear 30, thus providing a complete seal by the seal packing 61. The keep lever 46 is returned by the spring 45 so that the keep lever 46 comes into contact with the flange surface 47 of the suction nozzle 31, and the suction nozzle 31 moves upward. The next station Q is an idle station.

In the last working station R, in the case where the suction nozzle 31A having a directivity is selected in the aforementioned station P, the nozzle 31A is rotated by the rotating roller 50 of the rotating device in the direction in which the tipped parts 15A may be easily suctioned from the tape supply unit 18 in the first working station A. That is, the nozzle 31A is rotated so that the axial direction of the cylindrical tipped parts 15A supplied from the tape supply unit 18 is coincided with the direction of the groove 31B of the suction nozzle 31A.

In the case where in the aforementioned station P, the suction nozzle 31A is not selected, and the suction nozzle 31 is used while not being replaced, such as operation is not carried out.

And, in the first working station A, the suction nozzle 31A suctions the cylindrical tipped part 15A from the tape supply unit 18 which accommodates therein said parts 15A.

In the next station B, as described previously, the suction nozzle 31A is rotated by the rotating device while suctioning the tipped part 15A in the direction programmed in advance in the controller (not shown). That is, the suction nozzle is rotated in advance prior to positioning so that the tipped part 15A assumes a direction used when mounting.

Then, positioning is carried out. Since which working station is used and which positioning unit is used have already been determined when the tipped parts 15A are suctioned in the suctioning station A, the unit has already been moved before the suction nozzle 31A arrives. Accordingly, in case of these cylindrical tipped parts 15A, the positioning unit 90 has already been moved, in the positioning station E, to a position directly below the suction nozzle 31A scheduled to be arrived by the drive cylinder.

The positioning operation for the tipped parts 15A will be described. First, the positioning pawls 106A, 109A, 112A and 113A are opened by the pusher 103 (the other not shown), the suction nozzle 31A moves down and the pusher 103 and the like moves down to close the pawls 106A, 109A, 112A and 113A. With this, the planes 31C and 31D of the nozzle 31A are held by the pawls 112A and 113A to thereby determine the direction of an axis of the part 15A (see FIG. 24). At the same time, the axial direction of the part 15A is directly positioned by the pawls 106A and 109A. Even if the tipped part 15A is greatly deviated at the time of the aforesaid suction to be suctioned without entering the groove 31B and being transported to the positioning station E, the tipped part 15A can be urged by the pawls 112A and 113A, and therefore the part 15A is to be entered the groove 31B.

## Claims

(1) An electronic parts automatic mounting apparatus in which a plurality of suction nozzles are provided on the peripheral edge of an intermittently rotating turntable, tip-like electronic parts delivered from a part supply portion are suctioned and held by said suction nozzles, said electronic parts being transferred, positioned and mounted on a prints substrate placed on an XY table by the intermittent rotation of said turntable, said apparatus being provided with part adjusting means for subjecting the electronic parts suctioned and held by said suction nozzles to various stepwise adjusting works at a plurality of working stations provided on the way of transferring thereof, characterized in that said part adjusting means comprises a plurality of positioning working units for positioning electronic parts arranged in correspondence to one part positioning station of the working units, each of said positioning working units being selectively actuated according to the form of electronic parts having different sizes and shapes.

(2) The electronic parts automatic mounting apparatus accoridng to Claim 1, wherein said part adjusting means comprises a working station for detecting presence or absence of suction of electronic parts onto said suction nozzles prior to positioning of tip-like electronic parts, and a working station for detecting presence or absence and atttitude of electronic parts onto said suction nozzles after positioning of tip-like electronic parts.

(3) The electronic parts automatic mounting apparatus according to Claim 1 or 2, wherein said part adjusting means comprises a part-rotating working station separately from the positioning working station for the tip-like electronic parts.

(4) The electronic parts automatic mounting apparatus according to one of the Claims 1 to 3, wherein said suction nozzle is held by means of a holder, said holder being synchronized with the rotation of a turntable so that the holder may be moved upward and downward.

(5) The electronic parts automatic mounting apparatus according to one of the Claims 1 to 4, wherein means for positioning said suction nozzles per se is provided.

(6) The electronic parts automatic mounting apparatus according to one of the Claims 1 to 5, wherein means for rapidly moving down the suction nozzles at a station located before a part mounting station is provided while being guided by a vertical rail.

(7) An electronic parts automatic mounting apparatus accoridng to one of the Claims 2 to 6, wherein the detecting means comprises photosensors for detecting presence or absence of parts on the suction nozzles and at least one photosensor for detecting the attitude of the parts on the suction nozzles, the latter photosensor being movable by a driving motor.

(8) An electronic parts automatic mounting apparatus according to one of the Claims 1 to 7, wherein the positioning units are movable with respect to a frame which is linearly movable with respect to the turntable.

(9) An electronic parts automatic mounting apparatus according to claim 8, wherein each of the positioning units comprises a first opening and closing plate rotatable about a pin in a direction of opening a positioning pawl and a second opening and closing plate rotatable about a pin in response to the rotation of the first opening and closing plate to open a pawl, a pusher movable by a cam and acting upon the first plate and being biased into the closing direction by a spring with one end thereof supported on a fixed portion to hold the tipped part suctioned by the suction nozzle to position the part, the number of positioning pawls being four per unit with similar opening and closing of the pawls.

(10) An electronic parts automatic mounting apparatus according to claim 9, wherein the pawls are rotatable during the rotation of the turntable by a drive motor in the direction in which the tipped part suctioned by the suction nozzle is rotated.

FIG. 1

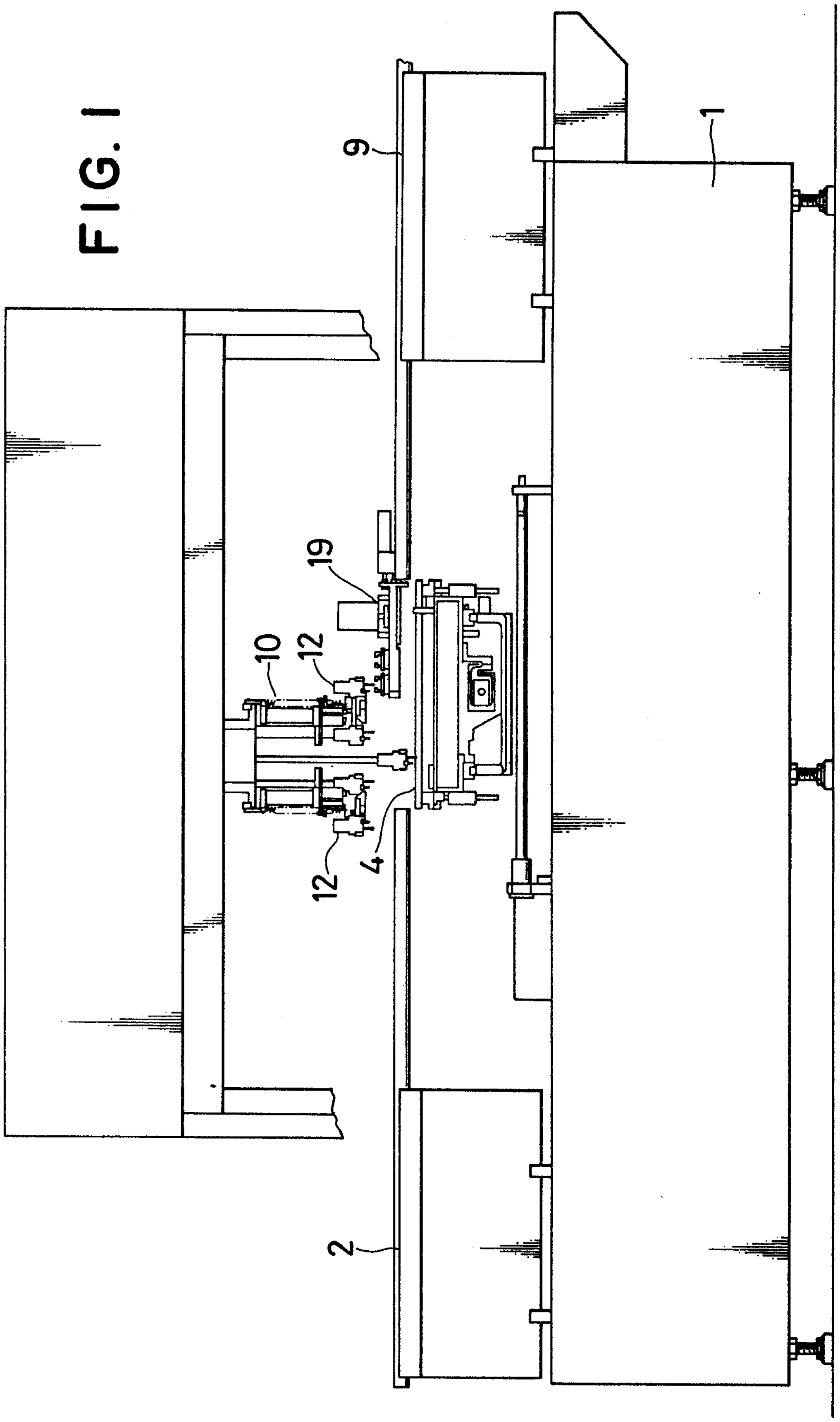

0275103

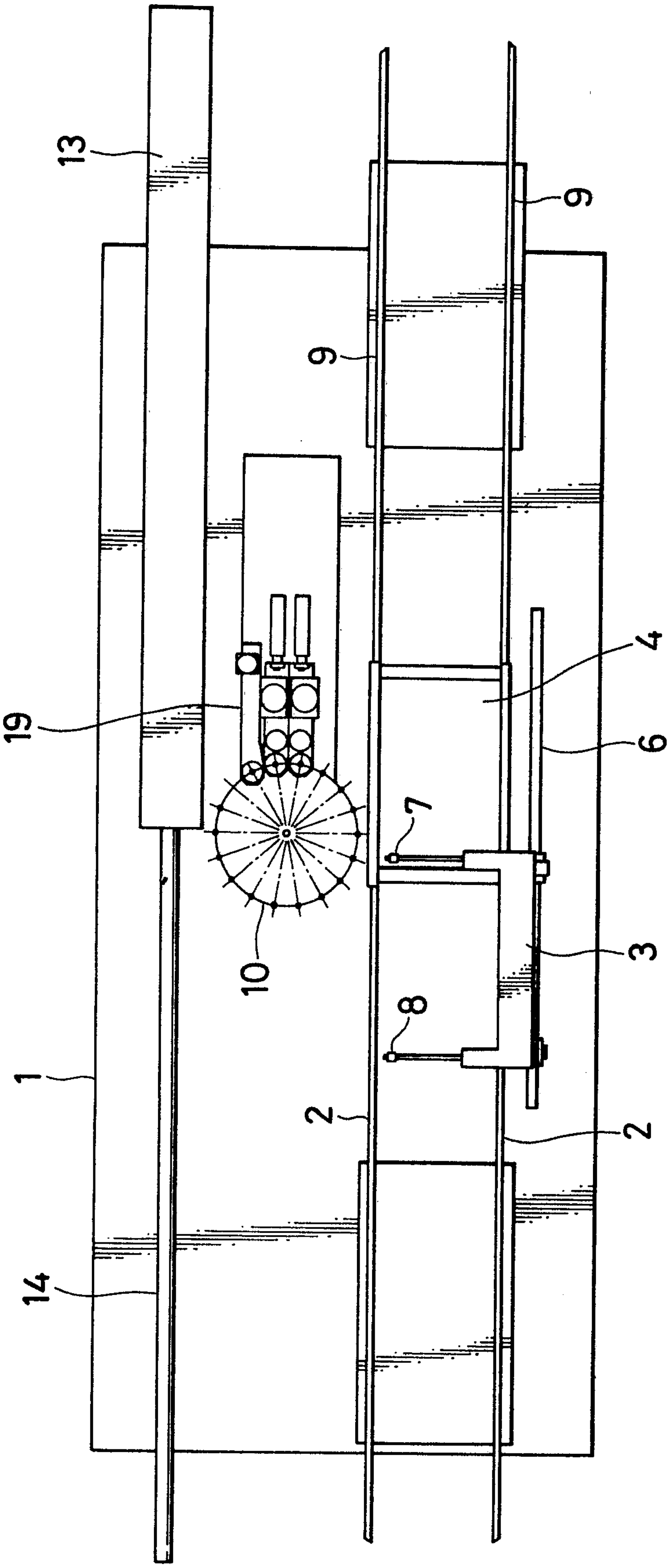


FIG.2

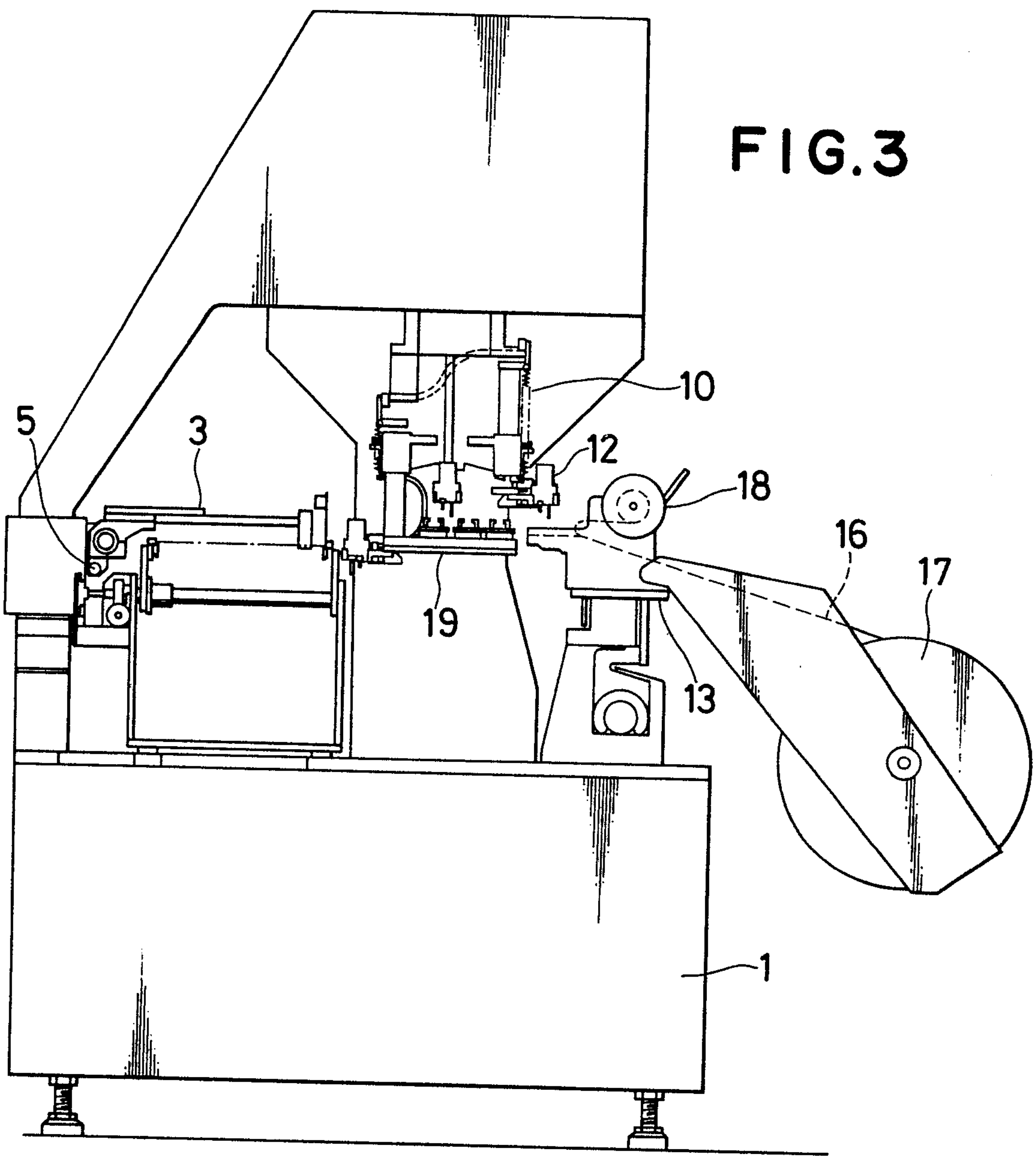


FIG.3

FIG. 4

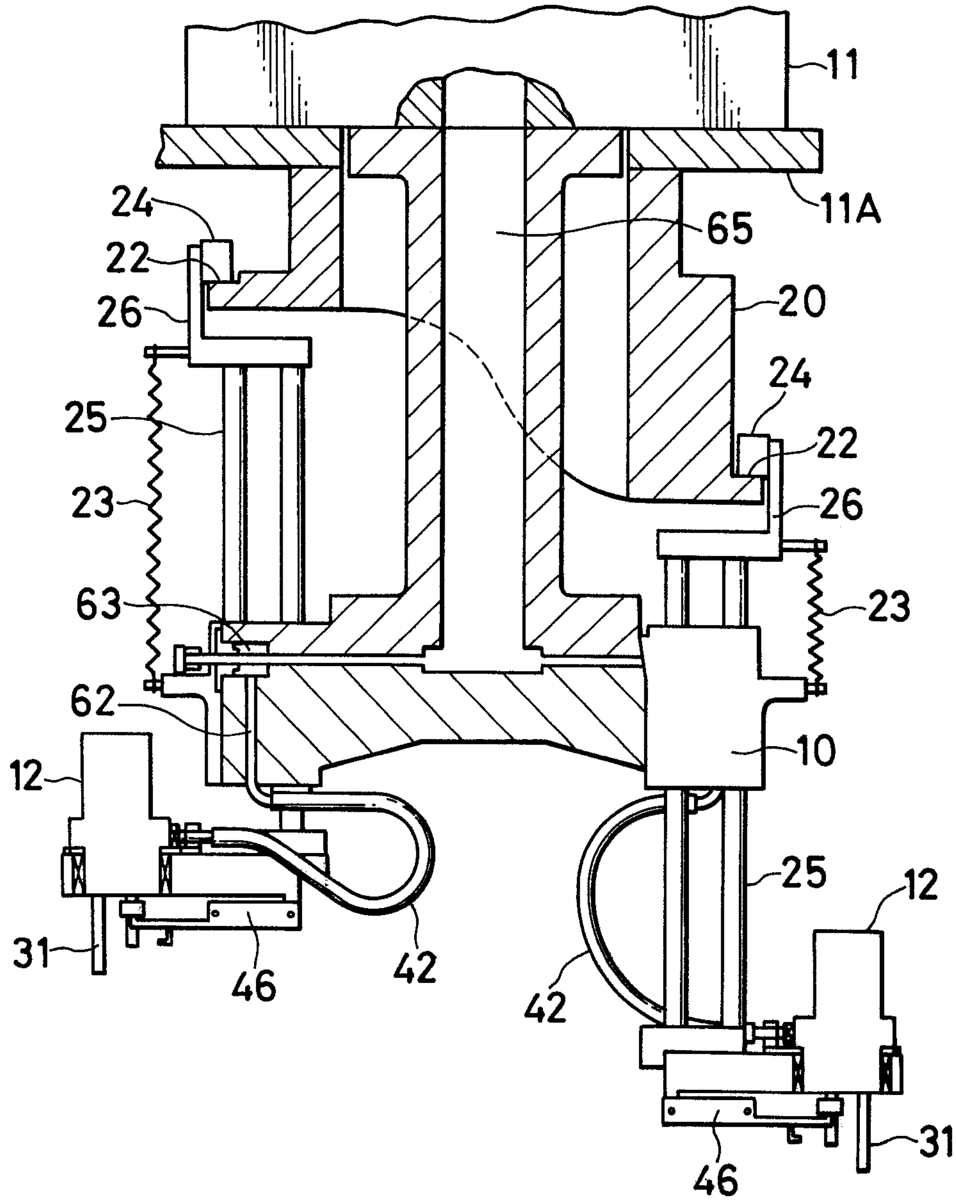

FIG.5

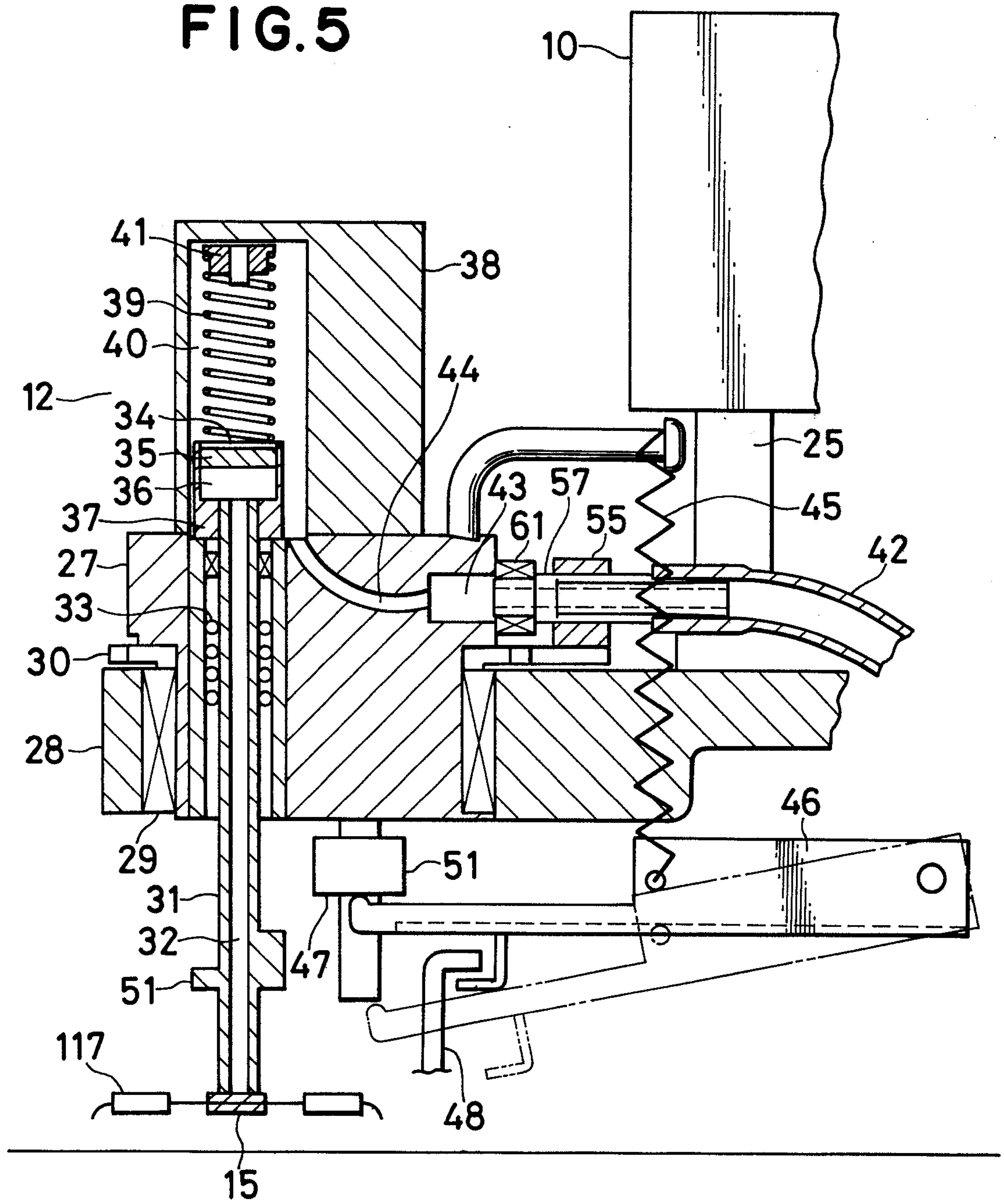
10
38
41
39
40
12
34
35
36
37
27
33
30
28
29
31
32
51
117
15
44
43
57
61
55
45
25
42
46
51
47
48

FIG. 6

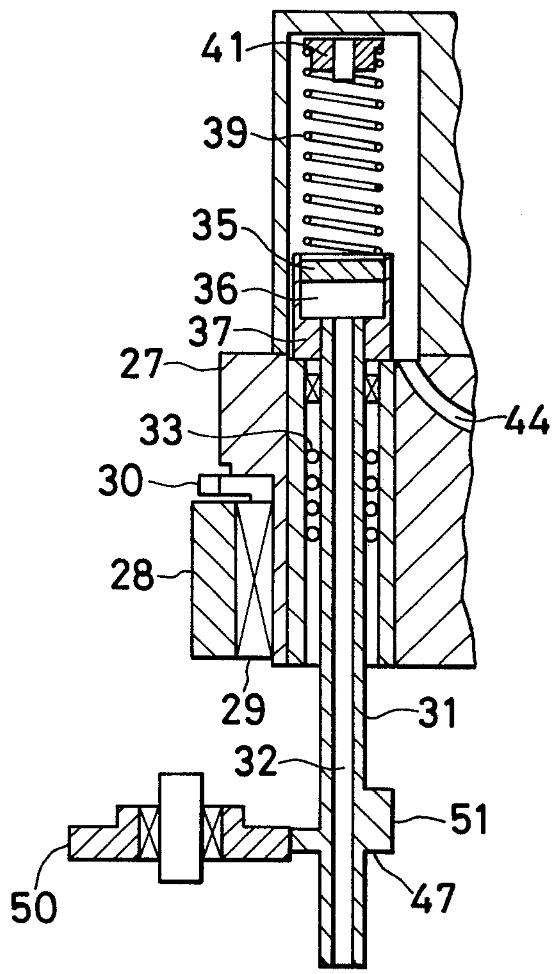

FIG.7

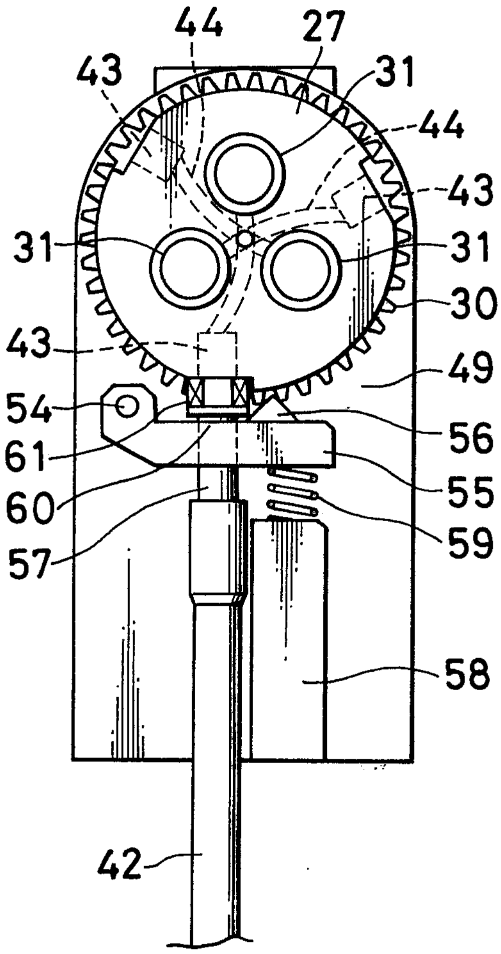
44
27
43
31
44
43
31
31
30
43
49
54
61
56
60
55
57
59
58
42

FIG.8

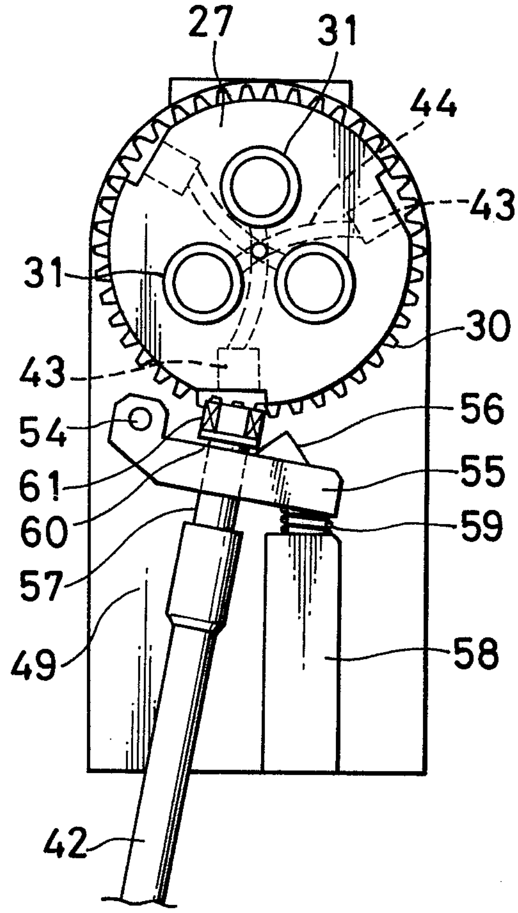
27
31
44
43
31
30
43
56
54
61
55
60
59
57
49
58
42

FIG.9

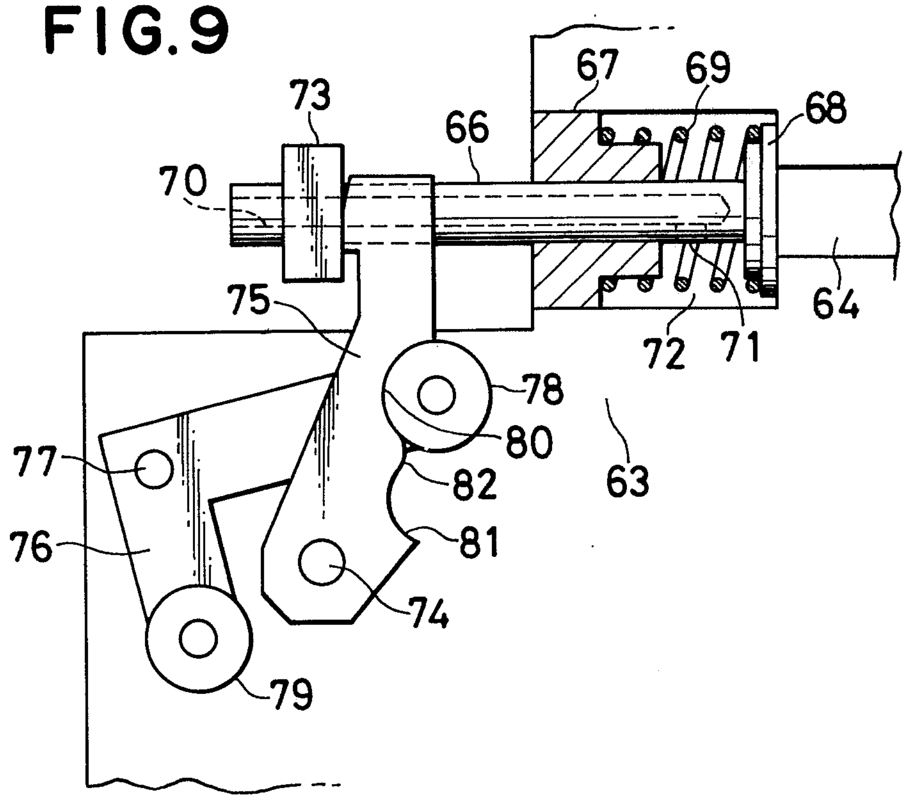
67
69
68
73
66
70
64
75
72
71
78
80
77
82
63
76
81
74
79

FIG.10

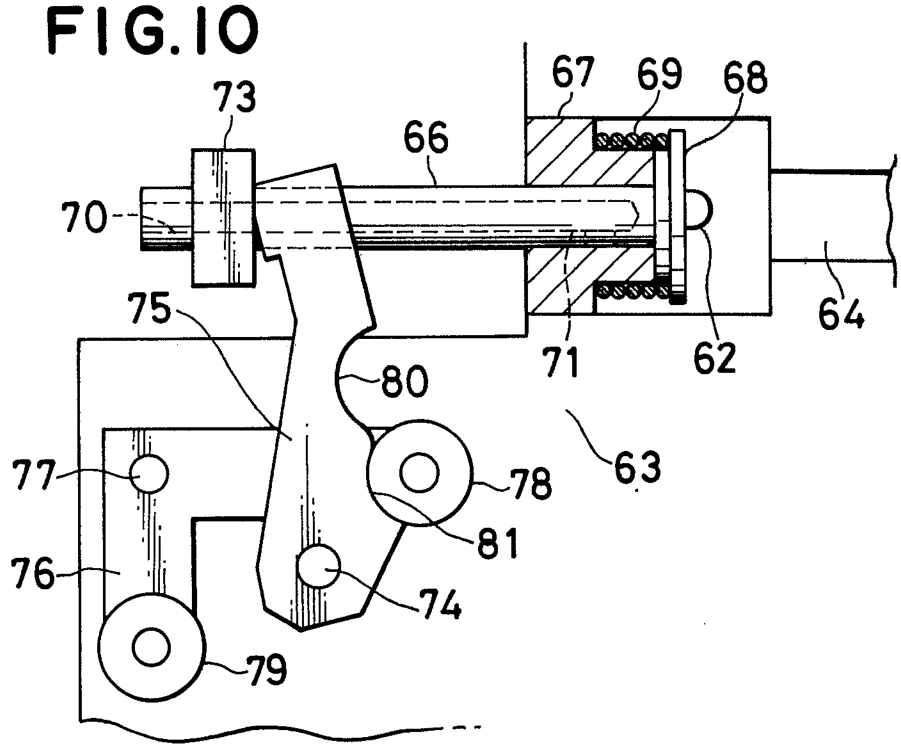
67
69
68
73
66
70
64
75
71
62
80
63
77
78
81
76
74
79

FIG.11

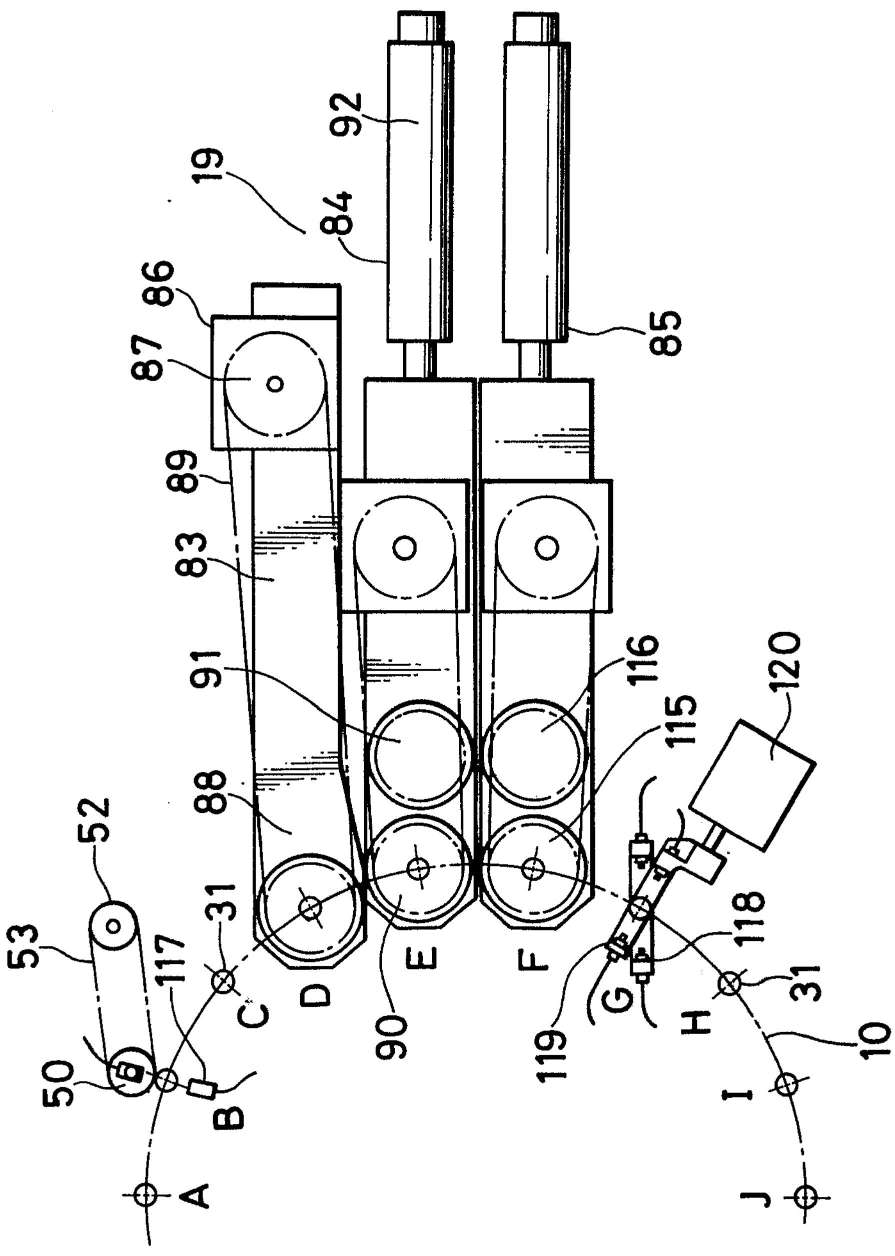

19
92
84
85
86
87
89
83
91
88
116
115
120
52
53
31
117
50
A
B
C
D
E
90
F
G
119
H
118
31
10
I
J

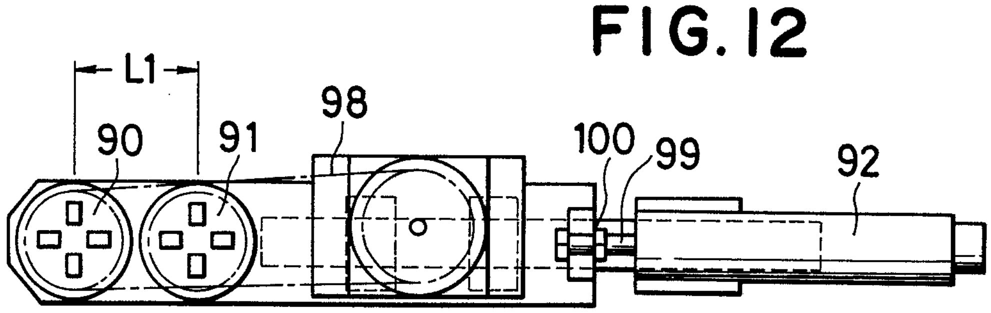


FIG.12

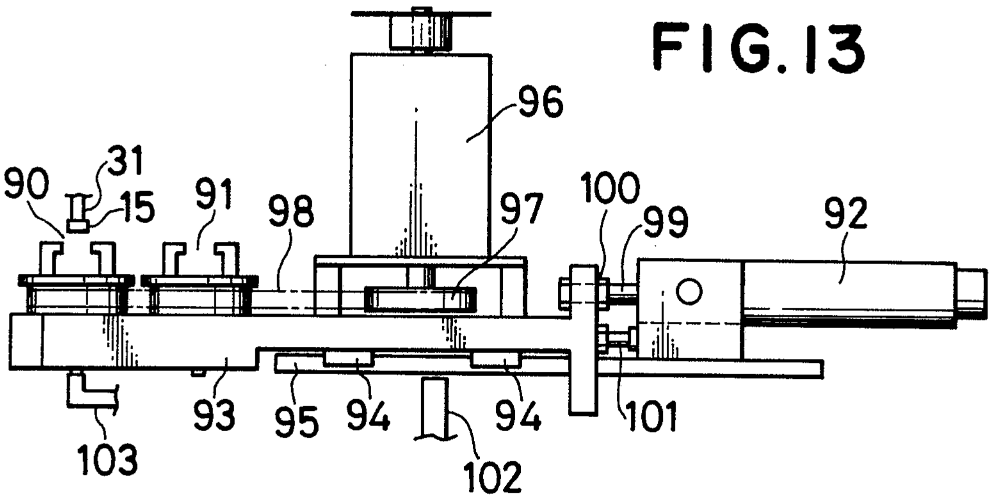


FIG.13

FIG.14

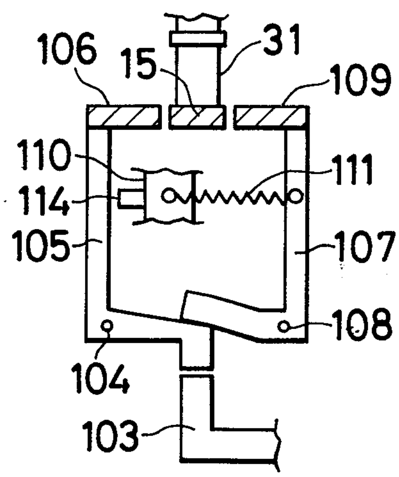


FIG.15

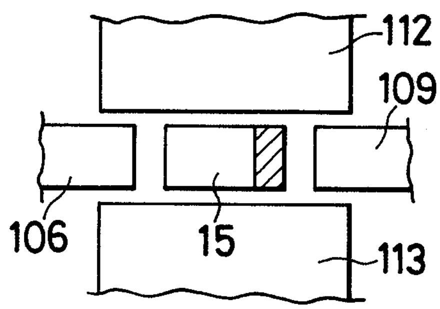


FIG.16

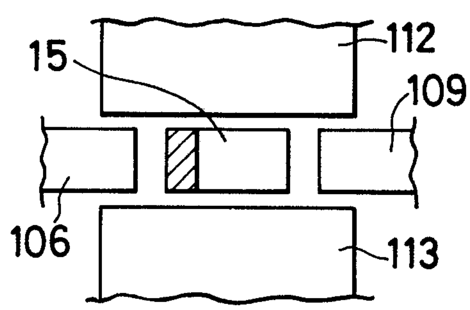

FIG.17

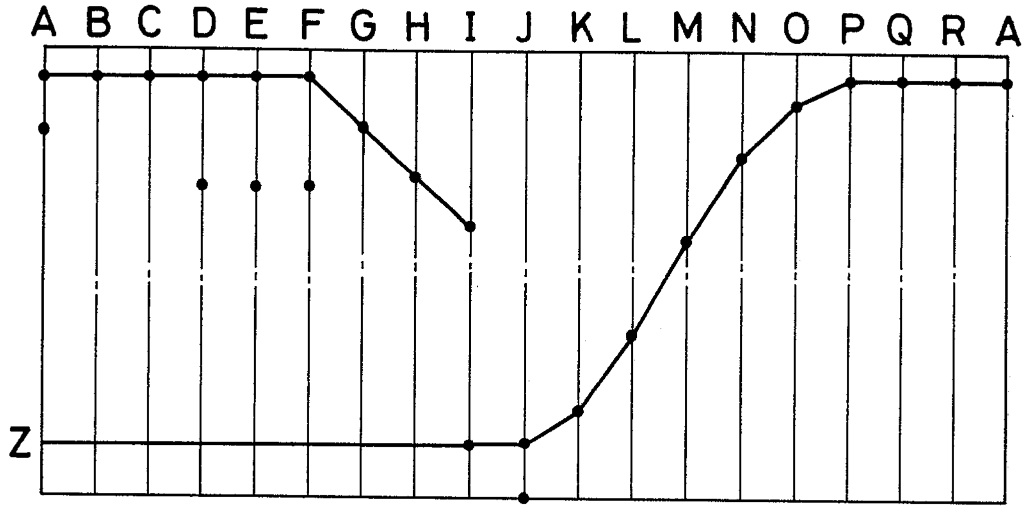
A B C D E F G H I J K L M N O P Q R A
Z

FIG.18

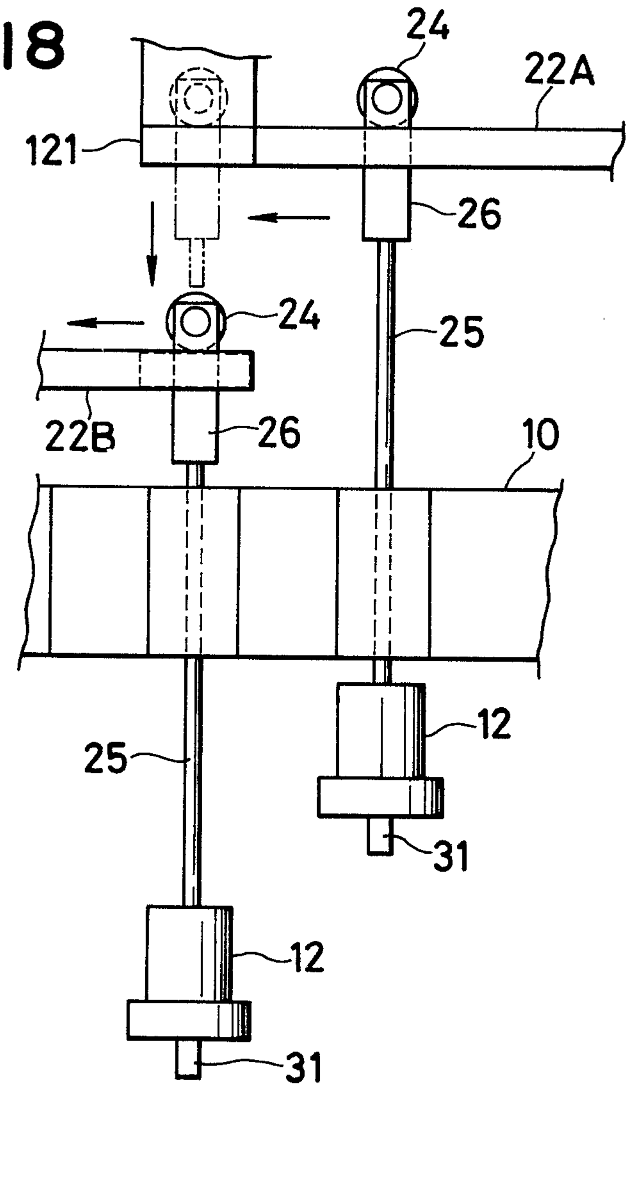
24
22A
121
26
24
25
22B
26
10
12
25
31
12
31

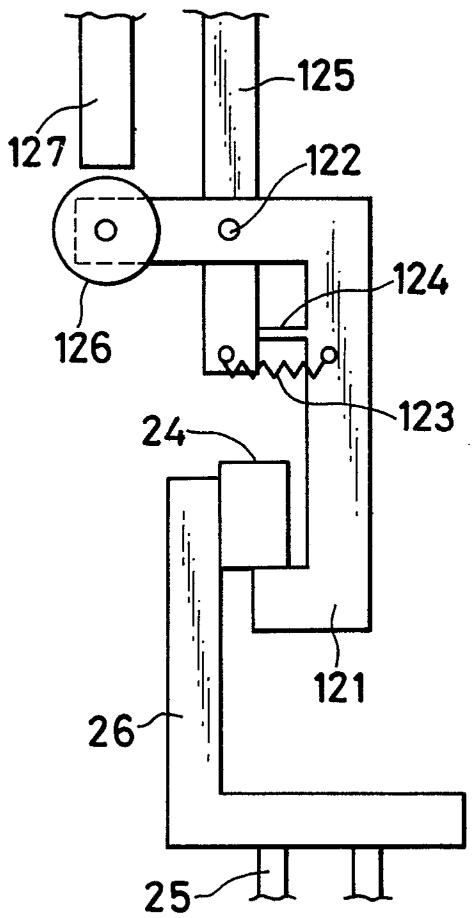
127
125
122
126
124
123
24
121
26
25

FIG.19

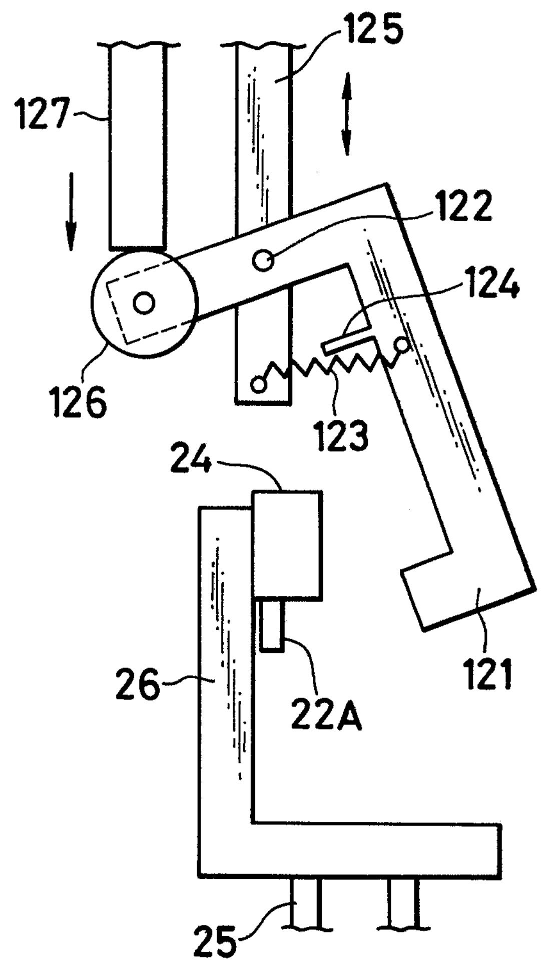
127
125
122
124
126
123
24
26
22A
121
25

FIG.20

FIG.21

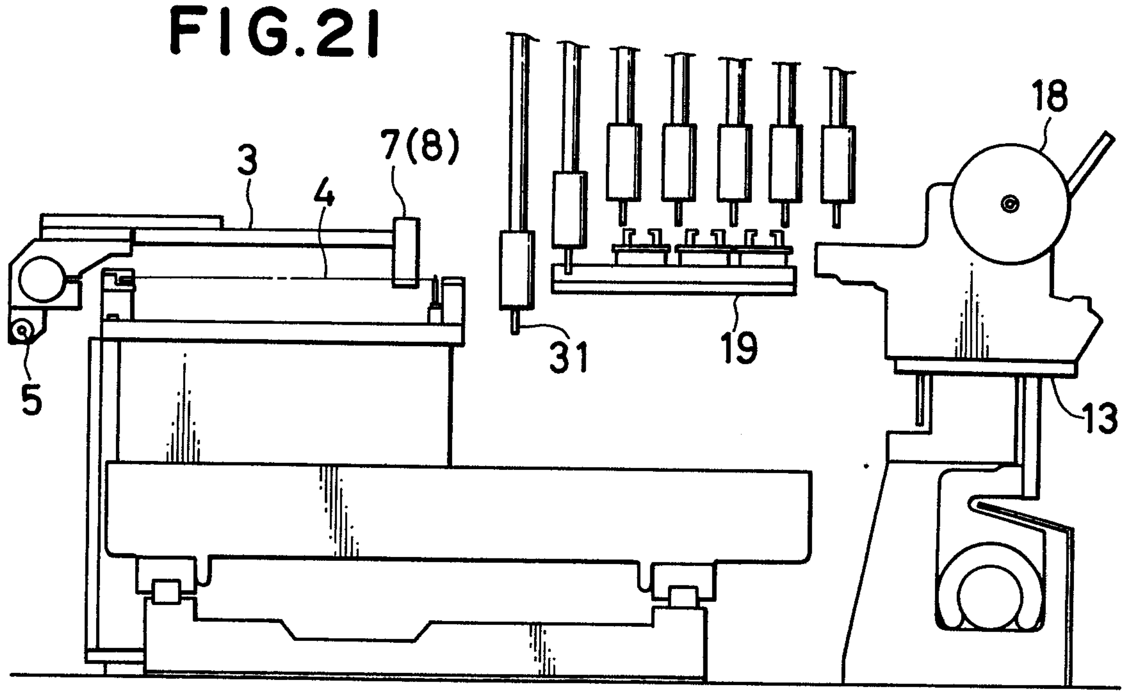


FIG.22

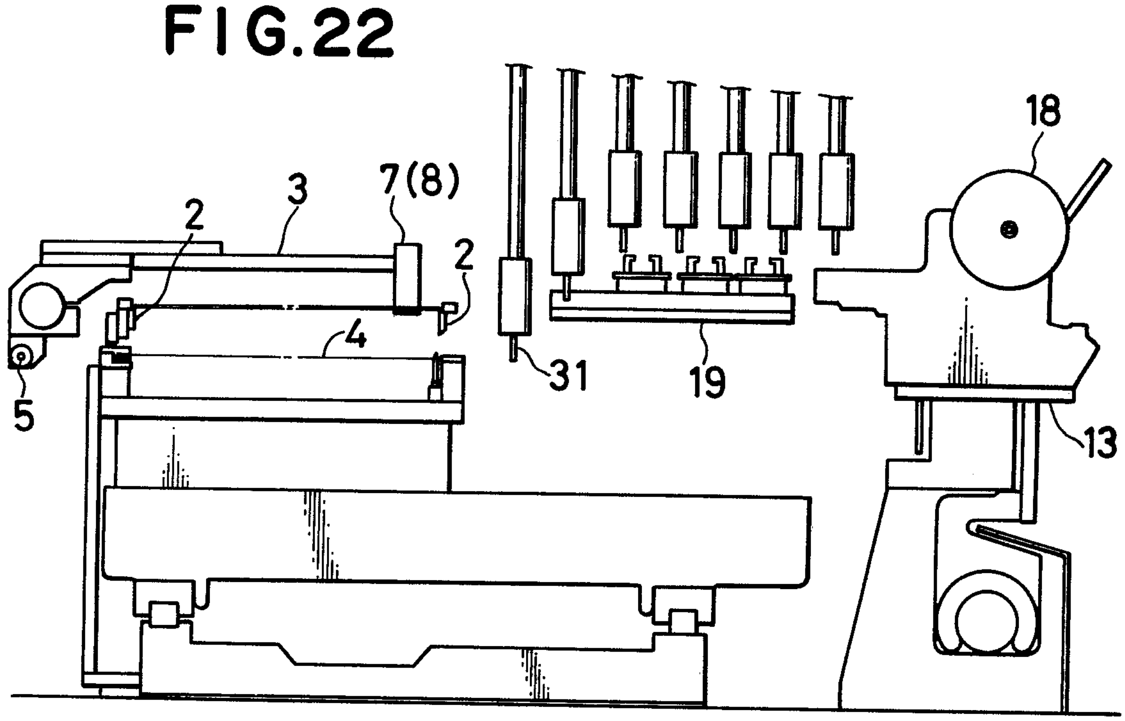

FIG.23

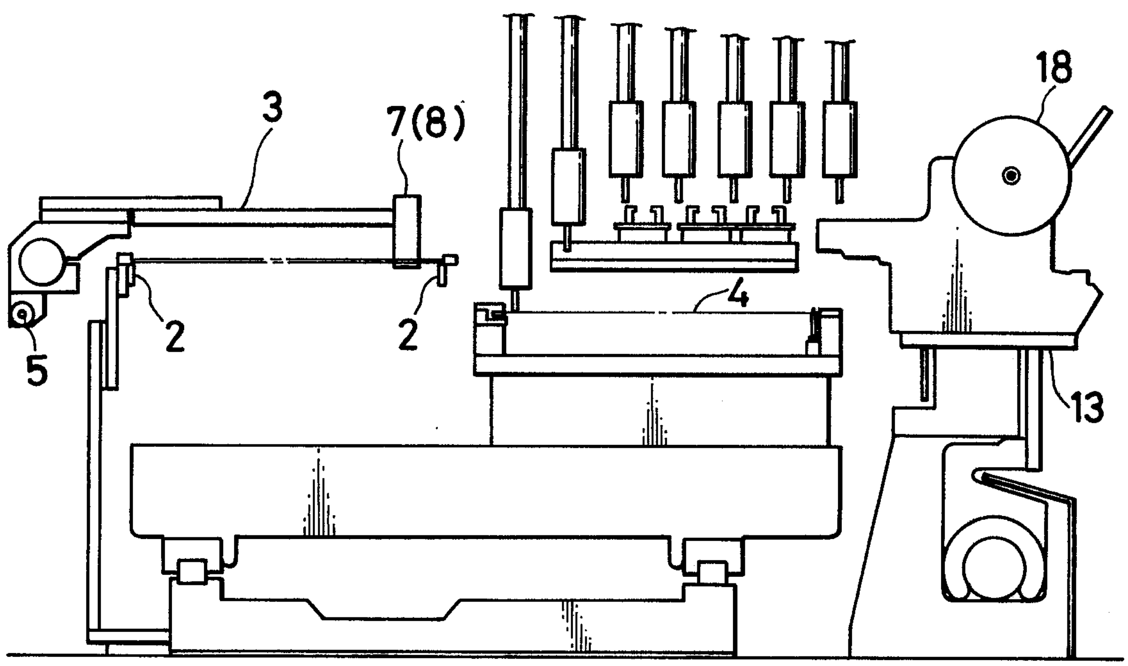

FIG.24

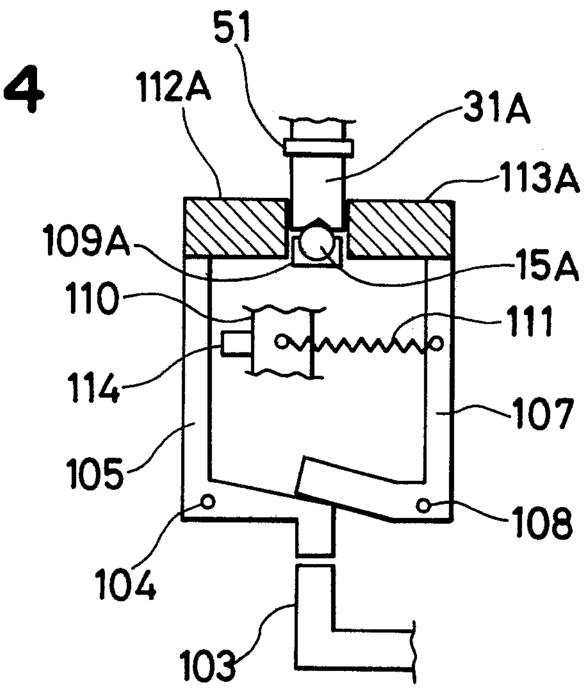
51
112A
31A
113A
109A
15A
110
111
114
107
105
108
104
103

FIG.25

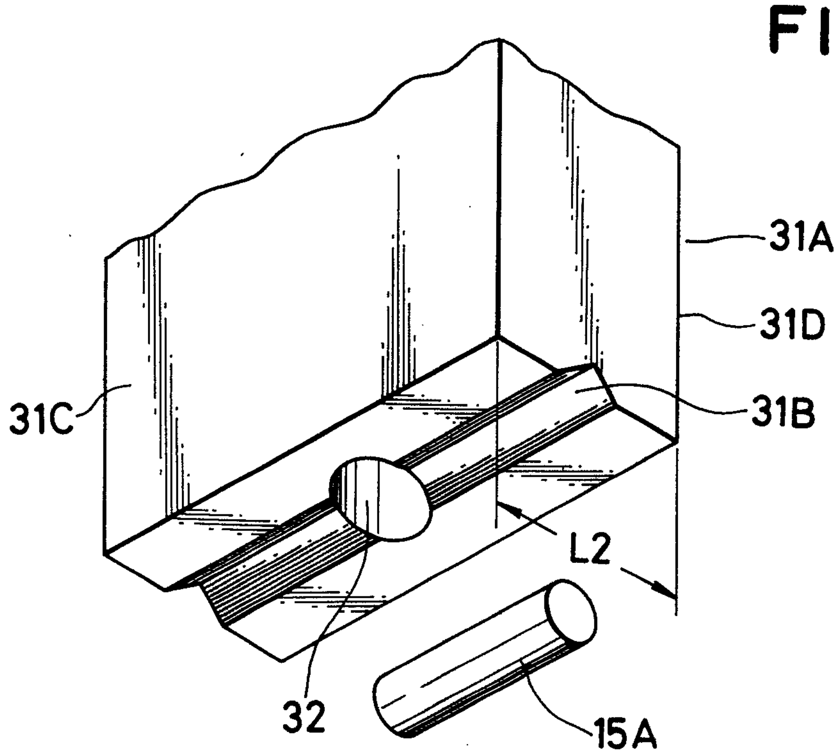
31A
31D
31C
31B
L2
32
15A

FIG.26

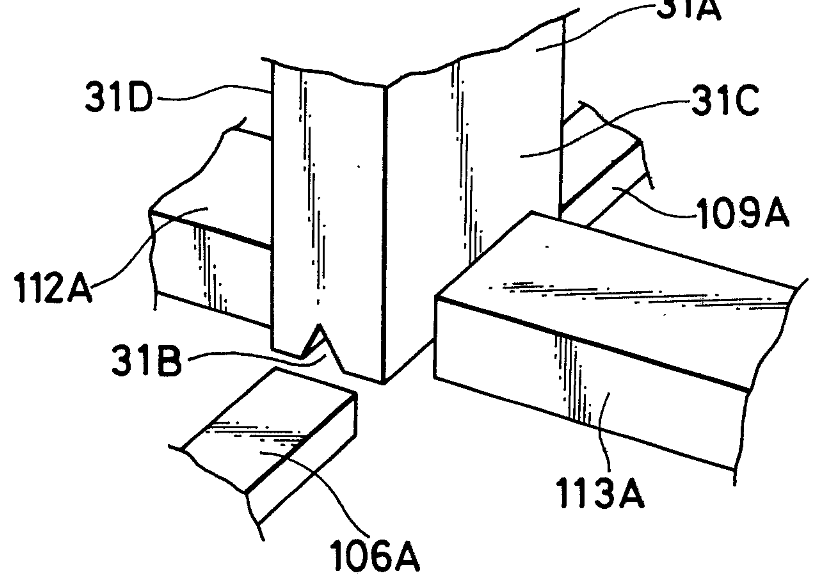


FIG.27